# EUROPEAN PATENT APPLICATION

(11) **EP 4 651 676 A1**
(43) Date of publication of application: **19.11.2025**
(21) Application number: 24916233.0
(22) Date of filing: 01.04.2024
(51) Int. Cl.: H10F 19/90, H10F 77/20, H10F 19/00, H10F 77/00, H10F 19/35

(54) **CELL STRING, CELL MODULE AND PHOTOVOLTAIC SYSTEM**

(30) Priority: 09.01.2024 CN 202420051820 U
(71) Applicant: Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, Jianjun, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2024/085309
(87) International publication number: WO 2025/148175

(57) **Abstract**

The present application provides a cell string (100), a cell module (200), and a photovoltaic system (1000). In the cell string (100), several back-contact solar cells (10) are arranged at intervals in a first direction. The backlight surface of the back-contact solar cells (10) is provided with P-type doped layers (11) and N-type doped layers (12) alternately arranged in a second direction, with both the P-type doped layers (11) and N-type doped layers (12) extending in the first direction. There is a spacer region between two adjacent back-contact solar cells (10). In the adjacent back-contact solar cells (10), the P-type doped layer (11) of one back-contact solar cell corresponds to the N-type doped layer (12) of the other back-contact solar cell in the first direction. Each conductive connector (20) is fixed and electrically connected to both the P-type doped layer (11) and the N-type doped layer (12). In the spacer region (101), in the second direction, every other conductive connector (20) is cut off. The cut-off conductive connector (20) forms a suspended segment (21) in the spacer region (101), and the length (L1) of the suspended segment (21) is less than the distance between two adjacent conductive connectors (20).

## Description

### PRIORITY INFORMATION

The present application claims the priority and benefit of patent application 202420051820.2, filed with the China National Intellectual Property Administration on 09 January 2024, which are incorporated in their entireties herein by reference.

### Technical Field

The present application relates to the technical field of solar cells, and in particular, to a cell string, a cell assembly, and a photovoltaic system.

### Background

Solar cell power generation is a sustainable source of clean energy, which can convert sunlight into electrical energy using the photovoltaic effect of a semiconductor p-n junction. In solar cells, a back-contact solar cell is a cell in which an emitter electrode and a base contact electrode are both placed on the back surface (the non-light receiving surface) of the cell, and the light-receiving surface of the cell is not shielded by any metal electrode, thereby effectively increasing a short-circuit current of a cell.

When forming a cell string of back-contact solar cells, sub-gates and main gates are usually formed on the cells using a patterning technology, and then the cells are connected in series by soldering solder strips on the main gates, so as to form the cell string. In such a technical solution, additional main gates need to be provided to implement current collection, and then the series connection of cells is implemented by soldering solder strips on the main gates, which has relatively high cost.

In the related art, in order to solve such a technical problem, instead of providing the main gates, a wire can be directly provided in the P-type region and the N-type region of the cell to directly contact the P-type region and the N-type region, and every other wire is cut off to directly achieve the series connection of cells. However, in such a technical solution, a part of the wire may be suspended when the conducting wire is cut off, and the suspended portion may easily bend and contact with adjacent conducting wires, causing a short circuit.

### Summary

The present application provides a cell string, a cell assembly and a photovoltaic system.

The present application is realized as follows. The cell string of the present application includes:
a plurality of back-contact solar cells arranged in a first direction, a backlight surface of each of the back-contact solar cells having a P-type doped layer and an N-type doped layer which are alternately arranged in sequence in a second direction, the P-type doped layer and the N-type doped layer having opposite polarities, and the second direction intersecting the first direction;
a spacer region provided between two adjacent back-contact solar cells, in the adjacent back-contact solar cells, a P-type doped layer of one back-contact solar cell corresponding to an N-type doped layer of the other back-contact solar cell in a first direction;
a plurality of conductive connectors, and the conductive connectors extend in the first direction, the plurality of conductive connectors are arranged at intervals in a second direction, each of the conductive connectors is located above the P-type doped layer and the N-type doped layer, and is fixedly and conductively connected to the P-type doped layer and the N-type doped layer, and each of the P-type doped layers and each of the N-type doped layers correspond to one of the conductive connectors;
at a position corresponding to the spacer region, in the second direction, every other conductive connector is cut off in a second direction,
and a suspended segment is formed at the spacer region of the cut-off conductive connectors, and the length of the suspended segment is less than a distance between two adjacent conductive connectors.

Still further, the number of back-contact solar cells is greater than two, and the cut-off conductive connectors are different in two adjacent spacer regions.

Still further, in the second direction, a distance between two adjacent conductive connectors is 0.3mm to 1.2mm.

Still further, in the first direction, a distance between two adjacent back-contact solar cells is 0.3 mm to 1.2 mm.

Still further, the back-contact solar cell further includes a plurality of metal grid lines provided corresponding to the P-type doped layer and the N-type doped layer, the metal grid lines on the P-type doped layer are in ohmic contact with the P-type doped layer, the metal grid lines on the N-type doped layer are in ohmic contact with the N-type doped layer, and the conductive connectors are fixedly connected to the metal grid lines.

Still further, the length of the suspended segment is less than a distance between the conductive connector and the metal grid line adjacent to the conductive connector in the second direction.

Still further, at a position corresponding to the spacer region, a shield layer is provided on the side of the conductive connector facing a light-receiving surface of the back-contact solar cell, and the color of the shield layer corresponds to that of the back-contact solar cell.

Still further, an end portion of the suspended segment is coated with an insulating coating, and the insulating coating wraps around the end portion of the suspended segment.

Still further, the color of the insulating coating corresponds to that of the back-contact solar cell.

The present application also provides a cell assembly. The cell assembly includes several of the described cell strings.

The present application further provides a photovoltaic system. The photovoltaic system includes the described cell assembly.

In the cell string, the cell assembly and the photovoltaic system of the embodiments of the present application, a spacer region is provided between two adjacent back-contact solar cells of the cell string; and in the adjacent back-contact solar cells, a P-type doped layer of one back-contact solar cell corresponds to an N-type doped layer of the other back-contact solar cell in a first direction. Each of the conductive connectors is located above the P-type doped layer and the N-type doped layer, and is fixedly and conductively connected to the P-type doped layer and the N-type doped layer. At a position corresponding to the spacer region, every other conductive connector is cut off in a second direction. A suspended segment is formed at the spacer region of the cut-off conductive connectors, and the length of the suspended segment is less than a distance between two adjacent conductive connectors. In this way, the back-contact solar cells can be directly connected in series by means of the conductive connectors to form a cell string, and short circuit can be avoided by cutting off every other conductive connector at the spacer region; if the length of the suspended segment formed by the cut-off conductive connector is less than a distance between two adjacent conductive connectors, it is possible to avoid current leakage caused by the cut-off suspended segment bending and coming into contact with adjacent conductive connectors, thereby ensuring the stability and reliability of the cell string.

Additional aspects and advantages of some embodiments of the present application will be given in part in the following description, become apparent in part from the following description, or be learned from the practice of some embodiments of the present application.

### Brief Description of the Drawings

Fig. 1 is a schematic diagram of the module of a photovoltaic system according to an embodiment of the present application;
Fig. 2 is a schematic diagram of the module of a cell assembly according to an embodiment of the present application;
Fig. 3 is a schematic diagram of a planar structure of a cell string according to an embodiment of the present application;
Fig. 4 is another schematic diagram of a planar structure of a cell string according to an embodiment of the present application;
Fig. 5 is yet another schematic diagram of a planar structure of a cell string according to an embodiment of the present application;
Fig. 6 is still another schematic diagram of a planar structure of a cell string according to an embodiment of the present application;
Fig. 7 is a schematic cross-segmental diagram of a cell string at a conductive connector in a first direction according to an embodiment of the present application;
Fig. 8 is another schematic cross-segmental diagram of a cell string at a conductive connector in a first direction according to an embodiment of the present application;
Fig. 9 is yet another schematic cross-segmental diagram of a cell string at a conductive connector in a first direction according to an embodiment of the present application.

Explanation of main components and symbols:
photovoltaic system 1000, cell assembly 200, cell string 100, back-contact solar cell 10, P-type doped layer 11, N-type doped layer 12, spacer region 101, conductive connector 20, suspended segment 21, first bus bar 30, second bus bar 40, metal grid line 50, shield layer 60, insulating coating 70.

### Detailed Description of the Embodiments

To make the objectives, technical solutions, and advantages of the present application clearer, the present application is further described in details below in combination with the drawings and embodiments. Examples of the embodiments will be illustrated in the accompanying drawings, and throughout the description, same or similar reference numerals represent same or similar elements or elements with same or similar functions. It should be noted that, the embodiments described below with reference to the accompanying drawings are illustrative, and are intended to illustrate the present application, and shall not be understood as limiting the present application. In addition, it should be understood that the specific embodiments described herein are only used to explain the present application, and are not intended to limit the present application.

In the description of the present application, it should be understood that, orientations or position relationships indicated by terms such as "upper", "lower", "left", "right", "transverse" and "longitudinal" and the like are orientations or position relationships based on accompanying drawings and are only for the convenience of illustration of the specification and simplicity of illustration, rather than explicitly or implicitly indicate that apparatuses or components referred to herein must have a certain direction or be configured or operated in a certain direction and therefore cannot be understood as limitations to the present application.

In addition, the terms "first" and "second" are only used for descriptive purposes, and cannot be understood as indicating or implying relative importance or implicitly indicating the number of indicated technical features. Thus, features defined by "first" and "second" may explicitly or implicitly comprise one or more of the features. In the description of the present application, "several" refers to two or more than two, unless specified otherwise.

In the present application, unless specified or limited otherwise, a first feature being "above" or "below" a second feature may comprise a direct contact between the first feature and the second feature, and may also comprise another feature contact between the first feature and the second feature rather than a direct contact. In addition, the first feature being "above", "over", and "on" the second feature includes the first feature being right above and obliquely above the second feature or only refers to the first feature being at a higher horizontal level than the second feature. The first feature being "below", "underneath", and "under" the second feature includes the first feature being right below and obliquely below the second feature or only refers to the first feature being at a lower horizontal level than the second feature.

The following disclosure provides many different embodiments or examples for implementing different structures of the present application. In order to simplify the disclosure of the present application, components and settings of specific examples are described below. Of course, they are merely examples and are not intended to limit the present application. Furthermore, the present application may repeat reference numerals and/or reference letters in different examples for the purpose of simplicity and clarity, and does not in itself indicate a relationship between the various embodiments and/or arrangements discussed. In addition, the present application provides examples of various specific processes and materials, but those skilled in the art will recognize the application of other processes and/or the use of other materials.

### Embodiment I

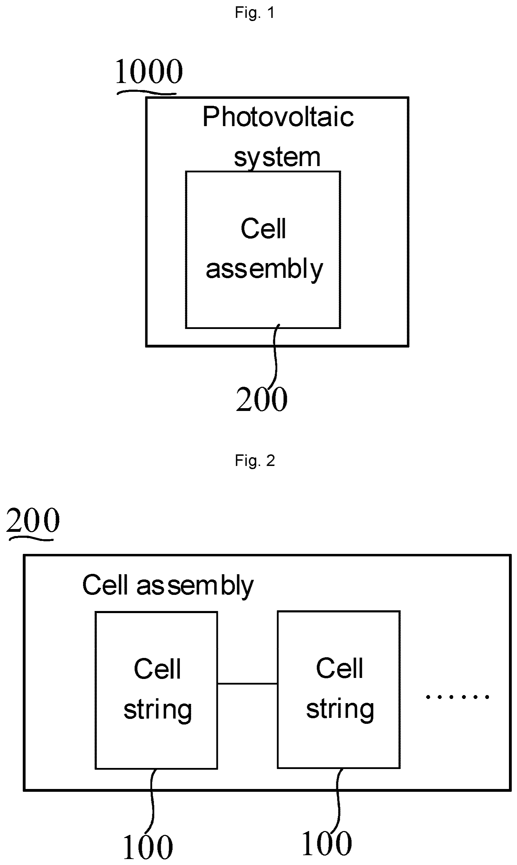

Please refer to Figs. 1 and 2, the photovoltaic system 1000 in the embodiment of the present application may comprise the cell assembly 200 in the embodiment of the present application, and the cell assembly 200 in the embodiment of the present application may comprise several cell strings 100 in the embodiment of the present application.

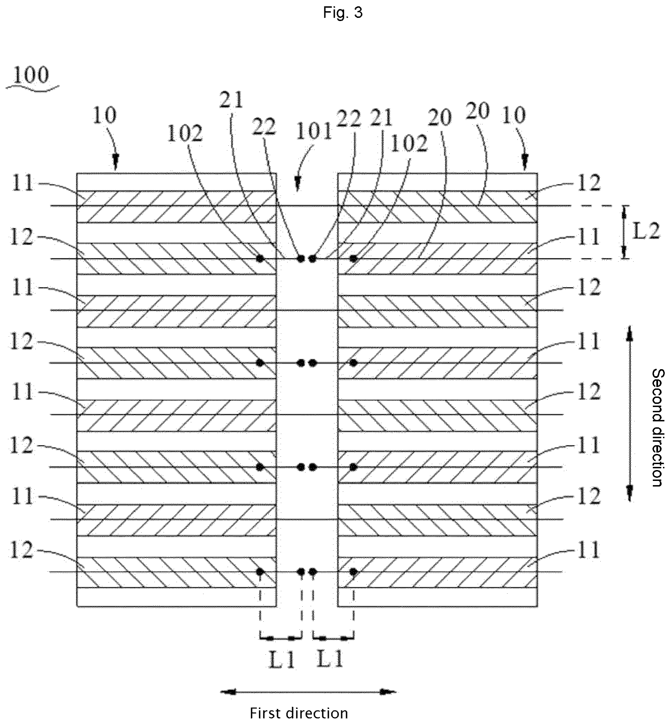

Please refer to Figs. 3 to 6, the cell string 100 in the embodiment of the present application may include several back-contact solar cells 10 and several conductive connectors 20.

The several back-contact solar cells 10 may be arranged at intervals in a first direction; a backlight surface of each of the back-contact solar cells 10 has a P-type doped layer 11 and an N-type doped layer 12 which are alternately arranged in sequence in a second direction; the P-type doped layer 11 and the N-type doped layer 12 both extend in the first direction; the polarities of the P-type doped layer 11 and the N-type doped layer 12 are opposite; and the first direction intersects the second direction.

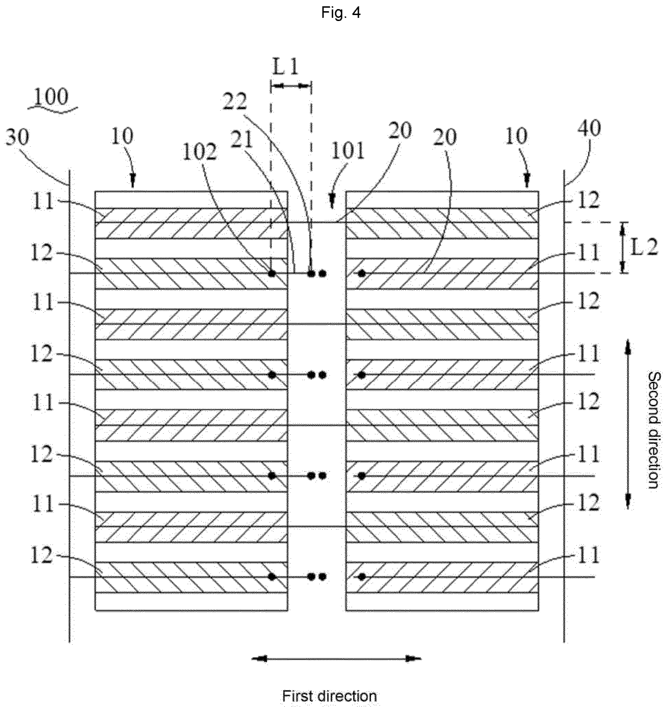

Specifically, the first direction may be a series connection direction of the cell strings 100 (i.e. a transverse direction in Fig. 3), the second direction may be a direction perpendicular to the series connection direction (i.e. a longitudinal direction in Fig. 4), and the two directions are perpendicular to each other.

As shown in Figs. 3 to 6, a spacer region 101 is provided between two adjacent back-contact solar cells 10, in the adjacent back-contact solar cells 10, a P-type doped layer 11 of one back-contact solar cell corresponding to an N-type doped layer 12 of the other back-contact solar cell in a first direction.

The conductive connectors 20 extend in the first direction, the several conductive connectors 20 are arranged at intervals in a second direction, each of the conductive connectors 20 is located above the P-type doped layer 11 and the N-type doped layer 12, and is fixedly and conductively connected to the P-type doped layer 11 and the N-type doped layer 12, and each of the P-type doped layers 11 and each of the N-type doped layers 12 correspond to one of the conductive connectors 20. That is, as shown in Figs. 3 to 6, for each of the conductive connectors 20, several P-type doped layers 11 and several N-type doped layers 12 are sequentially and alternately connected in the first direction.

As shown in Figs. 3 to 6, at a position corresponding to the spacer region 101, every other conductive connector 20 is cut off in a second direction. A suspended segment 21 is formed at the spacer region 101 of the cut-off conductive connectors 20, and the length L1 of the suspended segment 21 is less than a distance L2 between two adjacent conductive connectors 20.

It should be noted that, as shown in Fig. 3, the cut-off conductive connector 20 will form two end points 22 which will form two suspended segments 21; one of the two segments of the suspended segments 21 is a portion between one end point 22 formed by cutting off the conductive connector 20 and a fixing point 102, which is closest to the spacer region 102, between the conductive connector 20 and the P-type doped layer 11 (i.e. an edge fixing point between the conductive connector 20 and the P-type doped layer 11); and the other is a portion between the other end point 22 formed by cutting off the conductive connector 20 and a fixing point 102, which is closest to the spacer region 102, between the conductive connector 20 and the N-type doped layer 12 (i.e. the edge fixing point between the conductive connector 20 and the N-type doped layer 12). The length L1 of the suspended segment 21 is the distance between the endpoint 22 and the fixing point 102.

In the cell string 100, the cell assembly 200 and the photovoltaic system 1000 of the embodiments of the present application, a spacer region 101 is provided between two adjacent back-contact solar cells 10 of the cell string 100; and in the adjacent back-contact solar cells 10, a P-type doped layer 11 of one back-contact solar cell corresponds to an N-type doped layer 12 of the other back-contact solar cell in a first direction. Each of the conductive connectors 20 is located above the P-type doped layer 11 and the N-type doped layer 12, and is fixedly and conductively connected to the P-type doped layer 11 and the N-type doped layer 12. At a position corresponding to the spacer region 101, every other conductive connector 20 is cut off in a second direction. A suspended segment 21 is formed at the spacer region 101 of the cut-off conductive connectors 20, and the length L1 of the suspended segment 21 is less than a distance L2 between two adjacent conductive connectors 20. In this way, the back-contact solar cells 10 can be directly connected in series by means of the conductive connectors 20 to form a cell string 100, and a short circuit can be avoided by cutting off every other conductive connector 20 at the spacer region 101; if the length L1 of the suspended segment 21 formed by the cut-off conductive connector 20 is less than a distance L2 between two adjacent conductive connectors 20, it is possible to avoid current leakage caused by the cut-off suspended segment 21 bending and coming into contact with adjacent conductive connectors 20, thereby ensuring the stability and reliability of the cell string 100.

Specifically, in the present application, the number of the conductive connectors 20 corresponds to the sum of the number of the P-type doped layers 11 and the number the N-type doped layers 12 in each back-contact solar cell 10. For example, if the sum of the number of the P-type doped layers 11 and the number of the N-type doped layers 12 in the back-contact solar cell 10 is 50, the number of the conductive connectors 20 is also 50.

It can be understood that, different from the prior art in which current convergence is implemented by means of a main gate, and then a cell string is formed by connecting the main gate by means of a solder ribbon, in the present application, each of the P-type doped layers 11 of one of the back-contact solar cells 10 is first directly connected to a corresponding N-type doped layer 12 of the next back-contact solar cell 10 by means of continuous conductive connectors 20, and then the spacer region 101 between the two back-contact solar cells 10 cuts off every other conductive connector 20, thereby forming the cell string 100.

It should be noted that, "in two adjacent back-contact solar cells 10, one P-type doped layer 11 corresponds to the other N-type doped layer 12 in the first direction" may be understood as that, in two adjacent back-contact solar cells 10, one P-type doped layer 11 and the other N-type doped layer 12 are substantially located on the same straight line in the first direction.

The expression "at a position corresponding to the spacer region 101, in the second direction, every other conductive connector 20 is cut off" can be understood as that the Mth conductive connector 20 is continuous at the spacer region 101, and the (M+1)th conductive connector 20 is cut off at the spacer region 101, M being a positive integer. For example, in the second direction, if the first conductive connector 20 is cut off and, the second conductive connector 20 is not cut off, then from top to bottom, the conductive connectors 20 at odd positions are cut off, and the conductive connectors 20 at even positions are not cut off, that is, every other conductive connector 20 is cut off to form two suspended segments 21.

By the same reasoning, if the first conductive connector 20 is not cut off, and the second conductive connector 20 is cut off, then from top to bottom, the conductive connectors 20 at even positions are cut off, and the conductive connectors 20 at odd positions are not cut off.

In addition, it should be noted that, in the present application, the "distance between two adjacent conductive connectors 20" refers to a distance between two conductive connectors 20 in the second direction, that is, a distance between a lower edge of a previous conductive connector 20 and an upper edge of a next conductive connector 20.

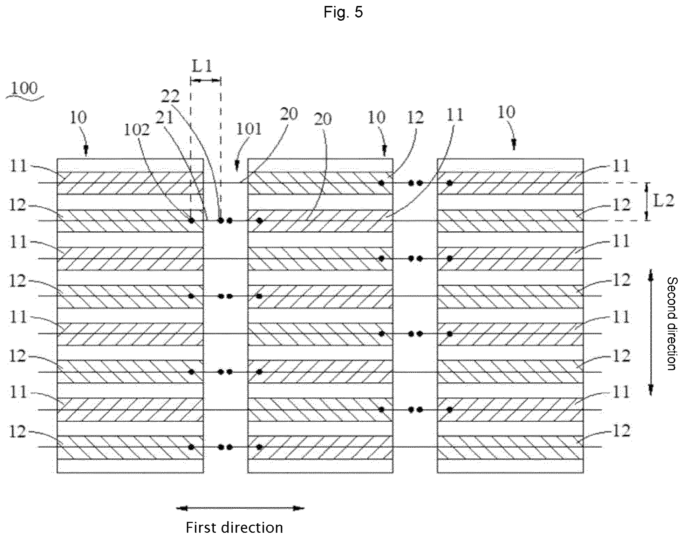

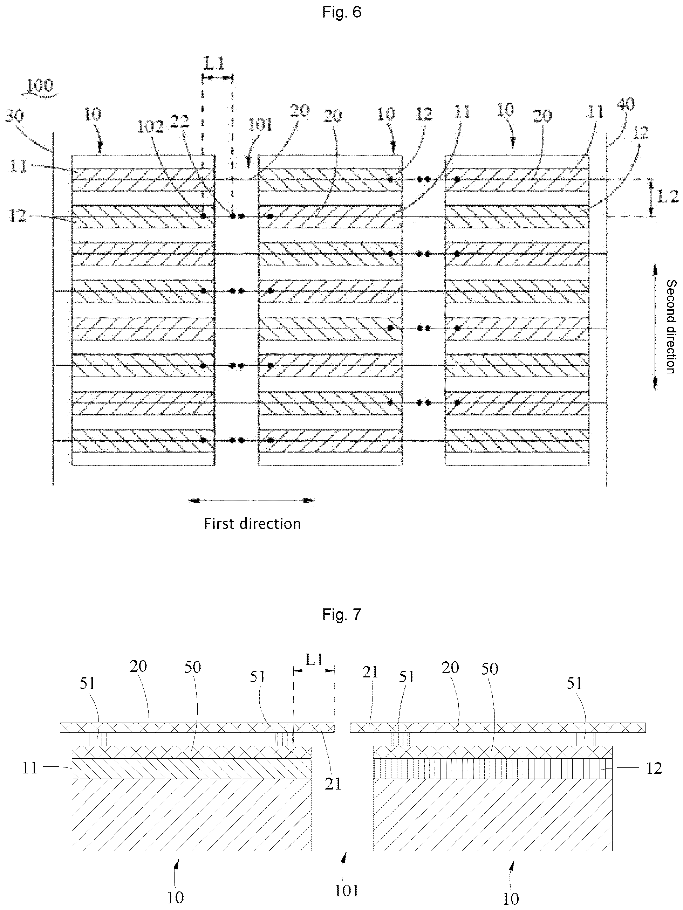

Refer to Figs 5 and 6, in some embodiments, the number of back-contact solar cells 10 is greater than two, and the cut-off conductive connectors 20 are different in two adjacent spacer regions 101.

In this way, if the number of back-contact solar cells 10 in the cell string 100 exceeds two, the cut-off conductive connectors 20 are different in two adjacent spacer regions 101, so that smooth collection of current can be achieved, to avoid a short circuit.

Specifically, as shown in Figs. 5 and 6, in two adjacent spacer regions 101, the Mth conductive connector 20 in one of the spacer regions 101 is cut off, and the (M+1)th conductive connector 20 is not cut off, then in another spacer region 101, the (M+1)th conductive connector 20 is cut off, and the Mth conductive connector 20 is not cut off, M being a positive integer.

As shown in Figs. 4 and 6, in the embodiment of the present application, the cell string 100 further includes a first bus bar 30 and a second bus bar 40 which are respectively located at two ends of the cell string 100. Among the several conductive connectors 20, every other conductive connector 20 is conductively connected to the first bus bar 30 and the second bus bar 40, thereby achieving the busbar output of the cell string 100.

Specifically, as shown in Figs. 4 and 6, two ends of the cell string 100 are respectively provided with a first bus bar 30 and a second bus bar 40; the conductive connector 20, which is cut off at the spacer region 101 closest to the first bus bar 30, is connected to the first bus bar 30, and the remaining conductive connectors 20 are not in contact with the first bus bar 30; the conductive connector 20, which is cut off at the spacer region 101 closest to the second bus bar 40, is connected to the second bus bar 40, and the remaining conductive connectors 20 are not in contact with the second bus bar 40.

For example, as shown in Fig. 4, the cell string 100 includes two back-contact solar cell sheets 10; there is only one spacer region 101; and in the spacer region 101, the conductive connectors 20 at even positions are cut off, then the conductive connectors 20 at even positions are connected to the first bus bar 30, and the conductive connectors 20 at odd positions are not connected to the first bus bar 30. By the same reasoning, the conductive connectors 20 at even positions are connected to the second bus bar 40, and the conductive connectors 20 at odd positions are not in contact with the second bus bar 40. On the contrary, if the conductive connectors 20 at odd positions are cut off, then the conductive connectors 20 at odd positions are connected to the first bus bar 30 and the second bus bar 40, and the conductive connectors 20 at even positions are not in contact with the first bus bar 30 and the second bus bar 40.

As another example, as shown in Fig. 6, the cell string 100 includes three back-contact solar cells 10; in the space region 101 closest to the first bus bar 30, the conductive connectors 20 at even positions are cut off, then the conductive connectors 20 at even positions are connected to the first bus bar 30, and the conductive connectors 20 at odd positions are not in contact with the first bus bar 30. In the spacer region 101 closest to the second bus bar 40, the conductive connectors 20 at odd positions are cut off, then the conductive connectors 20 at odd positions are connected to the second bus bar 40, and the conductive connectors 20 at even positions are not in contact with the second bus bar 40.

It should be understood that, in the embodiment of the present application, the cell assembly 200 may further comprise a metal frame, a back plate, photovoltaic glass, and an adhesive film (none of which is shown in the figure). The adhesive film may be filled between the front surface of the back-contact solar cell 10 and the photovoltaic glass, between the back surface and the back plate, between adjacent cells, etc.; as a filler, the adhesive film may be a transparent colloid having good light transmission and aging resistance, for example, the adhesive film may be an EVA adhesive film or a POE adhesive film, which may be selected according to actual situations, and is not limited herein.

The photovoltaic glass may cover the adhesive film on the front surface of the back-contact solar cell 10; the photovoltaic glass may be ultra-clear glass which has high light transmittance and high transparency, and has excellent physical, mechanical and optical properties; for example, the light transmittance of the ultra-clear glass may be up to 92% or more, and can protect the back-contact solar cell 10 without affecting the efficiency of the back-contact solar cell 10 as far as possible. In addition, the adhesive film may bond the photovoltaic glass and the back-contact solar cell 10 together, and the presence of the adhesive film may provide sealing, insulation, and waterproofing and moisture resistance for the back-contact solar cell 10.

The back plate can be attached to the adhesive film on the back surface of the back-contact solar cell 10; the back plate can protect and support the back-contact solar cell 10, and provide reliable insulation, water resistance and aging resistance; the back plate can have multiple choices, and can generally be tempered glass, organic glass, a TPT composite adhesive film of aluminum alloy, etc., and can be specifically set according to specific situations, which is not limited herein. The entirety composed of the back plate, the back-contact solar cell 10, the adhesive film and the photovoltaic glass can be provided on a metal frame; and the metal frame serves as a main external support structure of the whole cell assembly 200, and can stably support and mount the cell assembly 200, for example, by means of the metal frame, the cell assembly 200 can be mounted at a position required to be mounted.

Further, in the present embodiment, the photovoltaic system 1000 may be applied in a photovoltaic power plant, such as a surface power station, a rooftop power plant and a floating power plant, and may also be applied to a device or an apparatus that generates power using solar energy, such as a user solar power source, a solar street lamp, a solar-powered vehicle, and a solar-integrated building. Certainly, it can be understood that, the application scenarios of the photovoltaic system 1000 are not limited thereto, that is, the photovoltaic system 1000 may be applied in all fields that need to use solar energy to generate power. Taking a photovoltaic power generation system network as an example, the photovoltaic system 1000 may include a photovoltaic array, a combiner box and an inverter; the photovoltaic array may be an array combination of a plurality of cell assemblies 200, for example, the plurality of cell assemblies 200 may form a plurality of photovoltaic arrays, the photovoltaic arrays are connected to the combiner box; and the combiner box may collect currents generated by the photovoltaic arrays, and the collected currents are converted by the inverter into an alternating current required by the utility grid, and then are connected to the utility grid to implement solar power supply.

### Embodiment II

In some embodiments, a distance L2 between two adjacent conductive connectors 20 in the second direction may be 0.3mm to 1.2mm.

In this way, it is possible to avoid that the distance L2 between two adjacent conductive connectors 20 is too small, resulting in the length of the cut-off suspended segment 21 being too short, which increases the process difficulty when cutting off the conductive connector 20; in addition, it can also be avoided that the distance L2 between two adjacent conductive connectors 20 is too large, resulting in a small number of conductive connectors 20, which reduces the current carrier collection effect.

Specifically, in such embodiments, the distance L2 between two adjacent conductive connectors 20 may be, for example, 0.3 mm, 0.4 mm, 0.5 mm, 0.6 mm, 0.7 mm, 0.8 mm, 0.9 mm, 1 mm, 1.1 mm, and 1.2 mm.

### Embodiment III

In some embodiments, the distance between two adjacent back-contact solar cells 10 in the first direction (i.e., the width of the spacer region 101 in the first direction) may be 0.3 mm to 1.2 mm.

In this way, it can be avoided that the distance between two adjacent back-contact solar cells 10 is too small, resulting in inconvenient operation when cutting off the conductive connector 20; and it can also be avoided that the distance between two adjacent back-contact solar cells 10 is too large, resulting in a smaller number of back-contact solar cells 10 in a single cell string 100 of the same size.

Specifically, in such embodiments, the distance between two adjacent back-contact solar cells 10 may be, for example, 0.3 mm, 0.4 mm, 0.5 mm, 0.6 mm, 0.7 mm, 0.8 mm, 0.9 mm, 1 mm, 1.1 mm, and 1.2 mm.

### Embodiment IV

Refer to Fig. 7, in some embodiments, the back-contact solar cell 10 further includes several metal grid lines 50 provided corresponding to the P-type doped layer 11 and the N-type doped layer 12; the metal grid lines 50 on the P-type doped layer 11 are in ohmic contact with the P-type doped layer 11; the metal grid lines 50 on the N-type doped layer 12 are in ohmic contact with the N-type doped layer 12; and the conductive connector 20 is fixedly connected to the metal grid lines 50.

A portion between the endpoint 22 formed by the cut-off conductive connector 20 and the fixing point 102 of the cut-off conductive connector 20 and the metal grid line 50 closest to the spacer region 101 is the suspended segment 21.

In this way, the connection stability and reliability of the conductive connector 20 can be improved by soldering the conductive connector 20 to the metal grid line 50, and the conductive connector 20 can be effectively prevented from falling off.

Specifically, in such embodiments, the metal grid line 50 is a metal finger electrode; the metal grid line 50 on the P-type doped layer 11 is a P-type finger electrode; the metal grid line 50 on the N-type doped layer 12 is an N-type finger electrode; the metal grid line 50 is used for collecting currents of the P-type region and the N-type region, and then is connected in series by means of the conductive connector 20; and finally the bus bar output is realized by the described first bus bar 30 and second bus bar 40.

In such embodiments, the metal grid line 50 may be formed on the P-type doped layer 11 and the N-type doped layer 12 by printing and sintering, and the conductive connector 20 may be connected to the metal grid line 50 by soldering. For example, as shown in Fig. 7, the metal grid line 50 may have a several soldering points 51, and the conductive connector 20 may be soldered on the metal grid line 50 by means of the soldering points 51.

It is not difficult to understand that the soldering point 51 closest to the spacer region 101 is the fixing point 102 herein closest to the spacer region 101; the portion between the fixing point 102 and the end point 22 formed by the cut-ff conductive connector 20 is the suspended segment 21 of the conductive connector 20; the length of the suspended segment 21 is less than the distance between two adjacent conductive connectors 20, as a result, no matter how the suspended segment 21 bends or deforms, the suspended segment will not come into contact with the adjacent conductive connectors 20, thus avoiding a short circuit.

In some embodiments, the length of the suspended segment 21 is less than a distance between the conductive connector 20 and the metal grid line 50 adjacent to the conductive connector 20 in the second direction.

In this way, it is possible to prevent the suspended segment 21 from bending and contacting adjacent metal grid lines 50 having a different polarity, which could cause current leakage.

Specifically, "the distance between the conductive connector 20 and the metal grid line 50 adjacent to the conductive connector 20 in the second direction" refers to the distance between two opposite edges of the conductive connector 20 and the metal grid line 50 in the second direction. It can be understood that, in some embodiments, the width of the metal grid line 50 in the second direction is greater than that of the conductive connector 20, in such a case, the conductive connector 20 does not completely cover the metal grid line 50, thus, in order to prevent the suspended segment 21 from bending and contacting the edge of the adjacent metal grid line 50 to cause a short circuit, the length of the suspended segment 21 can be set to be less than the distance between the conductive connector 20 and the adjacent metal grid line 50.

### Embodiment V

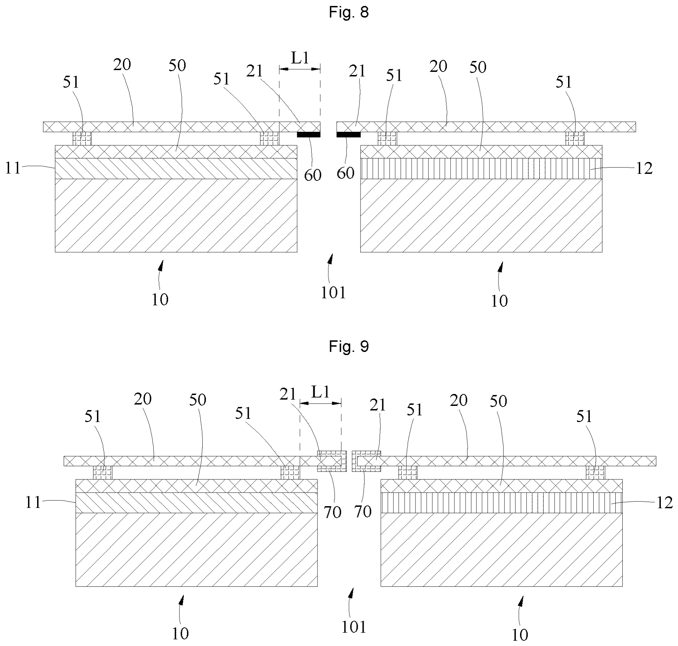

Please refer to Fig. 8, in some embodiments, at a position corresponding to the separation region 101, a shield layer 60 is coated on the side of the conductive connector 20 facing away from the light-receiving surface (i.e. the bottom surface in Fig. 8) of the solar cell 10, and the color of the shield layer 60 corresponds to the color of the back-contact solar cell 10. For example, when the back-contact solar cell 10 is blue, the color of the shield layer 60 may also be blue, and when the back-contact solar cell 10 is gold, the color of the shield layer 60 may also be gold.

In this way, the shield layer 60 of the same color as that of the back-contact solar cell is coated at the region of the conductive connector 20 exposed from the spacer region 101, so that the conductive connectors 20 of different colors can be prevented from being viewed from the front surface at the spacer region 101, ensuring the aesthetic appearance.

### Embodiment VI

Please refer to Fig. 9, in some embodiments, the end portion of the suspended segment 21 is coated with an insulating coating 70, and the insulating coating 70 wraps the end portion of the suspended segment 21.

In this way, the insulating coating 70 can be provided to prevent unintended electrical contact between the two end portions of the conductive connector 20 after the conductive connector has been cut off, thereby improving the reliability of the cell string 100.

Further, in such embodiments, the color of the insulating coating 70 corresponds to that of the back-contact solar cell 10. Thus, the aesthetic appearance of the entire cell string 100 can be ensured.

In the illustration of the description, the illustration of reference terms "an embodiment", "some embodiments", "an example", "a specific example", or "some examples" means that specific features, structures, materials, or characteristics described in connection with the embodiment or example is comprised in at least one embodiment or example the present application. In the description, the illustrative expressions of the described terms do not necessarily refer to the same embodiment or example. Furthermore, the specific features, structures, materials, or characteristics described may be combined in any suitable manner in one or more embodiments or examples.

In addition, the described content merely relates to preferred embodiments of the present application, and is not intended to limit the present application, and any modifications, equivalent replacements, improvements, etc. made within the spirit and principle of the present application shall all fall within the scope of protection of the present application.

## Claims

1. A cell string, comprising:
a plurality of back-contact solar cells arranged in a first direction, a backlight surface of each of the back-contact solar cells having a P-type doped layer and an N-type doped layer which are alternately arranged in sequence in a second direction, the P-type doped layer and the N-type doped layer having opposite polarities, and the second direction intersecting the first direction;
a spacer region provided between two adjacent back-contact solar cells, in the adjacent back-contact solar cells, a P-type doped layer of one back-contact solar cell corresponding to an N-type doped layer of the other back-contact solar cell in a first direction;
a plurality of conductive connectors, wherein the conductive connectors extend in the first direction, the plurality of conductive connectors are arranged at intervals in a second direction, each of the conductive connectors is located above the P-type doped layer and the N-type doped layer, and is fixedly and conductively connected to the P-type doped layer and the N-type doped layer, and each of the P-type doped layers and each of the N-type doped layers correspond to one of the conductive connectors;
at a position corresponding to the spacer region, in the second direction, every other conductive connector is cut off in a second direction,
wherein a suspended segment is formed at the spacer region of the cut-off conductive connectors, and the length of the suspended segment is less than a distance between two adjacent conductive connectors.

2. The cell string according to claim 1, wherein a number of the back-contact solar cells is greater than two, and the cut-off conductive connectors are different in two adjacent spacer regions.

3. The cell string according to claim 1, wherein in the second direction, a distance between two adjacent conductive connectors is 0.3mm to 1.2mm.

4. The cell string according to claim 1, wherein in the first direction, a distance between two adjacent back-contact solar cells is 0.3 mm to 1.2 mm.

5. The cell string according to claim 1, wherein the back-contact solar cell further includes a plurality of metal grid lines provided corresponding to the P-type doped layer and the N-type doped layer, the metal grid lines on the P-type doped layer are in ohmic contact with the P-type doped layer, the metal grid lines on the N-type doped layer are in ohmic contact with the N-type doped layer, and the conductive connectors are fixedly connected to the metal grid lines.

6. The cell string according to claim 5, wherein a length of the suspended segment is less than a distance between the conductive connector and the metal grid line adjacent to the conductive connector in the second direction.

7. The cell string according to claim 1, wherein at a position corresponding to the spacer region, a shield layer is provided on the side of the conductive connector facing a light-receiving surface of the back-contact solar cell, and the color of the shield layer corresponds to that of the back-contact solar cell.

8. The cell string according to claim 1, wherein an end portion of the suspended segment is coated with an insulating coating, and the insulating coating wraps around the end portion of the suspended segment.

9. The cell string according to claim 8, wherein the color of the insulating coating corresponds to that of the back-contact solar cell.

10. A cell assembly, comprising several cell strings according to any one of claims 1 to 9.

11. A photovoltaic system, comprising the cell assembly according to claim 10.
